(19) Europäisches Patentamt

European Patent Office

Office européen des brevets

(11) Veröffentlichungsnummer: **0 315 739 B1**

(12) **EUROPÄISCHE PATENTSCHRIFT**

(45) Veröffentlichungstag der Patentschrift: **25.11.92**

(21) Anmeldenummer: **88113095.9**

(22) Anmeldetag: **12.08.88**

(51) Int. Cl.⁵: **H05K 3/00, H05K 13/00**

(54) **Vorrichtung zum Trennen und Besäumen von Leiterplatten.**

(30) Priorität: **07.11.87 DE 3737868**

(43) Veröffentlichungstag der Anmeldung:
**17.05.89 Patentblatt 89/20**

(45) Bekanntmachung des Hinweises auf die
Patenterteilung:
**25.11.92 Patentblatt 92/48**

(84) Benannte Vertragsstaaten:
**AT BE CH DE FR GB IT LI LU NL SE**

(56) Entgegenhaltungen:
**DE-A- 3 415 932**
**GB-A- 2 050 895**
**US-A- 3 556 366**
**US-A- 4 295 198**

(73) Patentinhaber: **Löhr & Herrmann GmbH**
**Hesselbachstrasse 15**
**W-7531 Neuhausen(DE)**

(72) Erfinder: **Löhr, Hans-Günter, Dr.-Ing.**
**Ahornweg 3**
**W-7135 Wiernsheim(DE)**
Erfinder: **Herrmann, Gunter, Dr.-Ing.**
**Hindenburgstrasse 21**
**W-7260 Calw(DE)**
Erfinder: **Mozzi, Josef Walter**
**Landhausstrasse 20**
**W-7267 Unterreichenbach(DE)**
Erfinder: **Claus, Dieter**
**Grabengasse 3**
**W-6365 Rosbach-Rodheim(DE)**

(74) Vertreter: **Hubbuch, Helmut, Dipl.-Ing et al**
**Patentanwälte Dr. Rudolf Bauer Dipl.-Ing.**
**Helmut Hubbuch Dipl.-Phys. Ulrich Twelmei-**
**er Westliche Karl-Friedrich-Strasse 29-31**
**W-7530 Pforzheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Vorrichtung zum Trennen und Besäumen von Leiterplatten, insbes. mehrlagigen Leiterplatten (Multilayers) nach dem Oberbegriff des Patentanspruchs 1, siehe GB-A-2 050 895.

Solche mehrlagigen Leiterplatten werden hergestellt, indem auf eine Außenlage nacheinander die Kunstharz-Zwischenlagen und Leiterplatten-Innenlagen im Wechsel aufgeschichtet werden, wobei die Position der verschiedenen Lagen mittels geeigneter Positionshilfen, wie z.B. Fangstiften, bestimmt wird. Anschließend werden die Leiterplatten unter Einwirkung von Hitze und Druck verpreßt. Dabei wird das Kunstharz fließfähig und fließt in der Fläche nach außen über die Leiterplatten-Kontur hinaus und bildet dort nach dem Abkühlen und Erstarren einen undefinierten, mehr oder weniger breiten Rand. Häufig werden die Leiterplatten größer zugeschnitten als dem späteren Nutzformat entspricht, so daß der ausgeflossene Kunstharzrand zwischen dem überschüssigen Leiterplatten-Rand eingeschlossen bleibt.

Vor der Weiterbearbeitung muß dieser Rand bzw. der Kunstharz-Rand maßgenau abgetrennt werden. zugleich soll die nach dem Abtrennen des Randes entstandene Kante des zugeschnittenen Multilayers gratfrei sein und profiliert werden, um Fehler in der Weiterbearbeitung durch lose Partikel und scharfe Kanten zu vermeiden. Hierzu sind Verfahren bekannt, bei denen mittels Schlag- oder Rollscheren der Rand abgeschnitten wird. Ferner sind Fräsmaschinen bekannt, bei denen der Fräser entlang der feststehenden Leiterplatte fährt und die Kontur abfräst. Diese Verfahren haben den Nachteil, daß sie die Kante nicht nachbearbeiten. Je nach Verfahren werden die Leiterplatten außerdem hoch beansprucht; auch ist die Bearbeitungsgeschwindigkeit oft sehr gering und die bearbeitete Leiterplatten-Dicke begrenzt.

Der Erfindung liegt nun die Aufgabe zugrunde, eine Vorrichtung zu schaffen, mit der mehrlagige Leiterplatten (Multilayers) unterschiedlicher Formate, sowie auch einfache Leiterplatten maßgenau mit hoher Geschwindigkeit, geringer Belastung derselben, bei Verwendung unterschiedlicher Positionierhilfen gratfrei getrennt und besäumt werden können und im gleichen Arbeitsgang die Kanten profiliert werden. Ferner soll die Umrüstung auf andere Formate einfach und schnell möglich sein.

Die Vorrichtung zum Trennen und Besäumen von Leiterplatten, insbes. mehrlagigen Leiterplatten (Multilayers), kennzeichnet sich zur Lösung dieser Aufgabe durch die im kennzeichnenden Teil des Patentanspruchs 1 angegebenen Lösungsmerkmale.

Hierzu werden die Leiterplatten horizontal auf einen Rundschalttisch mit auswechselbarer Aufspannplatte gelegt und dort mit Fangstiften bzw. dem bei der Herstellung der Leiterplatte verwendeten Positioniersystem fixiert. Die Aufspannplatte ist hierbei um einige Millimeter kleiner als das spätere Nutzformat der Leiterplatte, so daß der abzuschneidende Rand übersteht. Der Rundschalttisch ist einerseits auf einem Kreuztisch montiert, dessen beide Achsen (X, Y) mittels Position und Geschwindigkeit regelbaren Motoren angetrieben werden, die hohe Verkehrsgeschwindigkeiten ermöglichen. Die aufgespannte Leiterplatte wird mit dem Kreuztisch positionsgenau an einem Sägen-Paar mit besonders profilierten Diamant-Schneiden vorbeigeführt, wobei zunächst eine Seite besäumt und gleichzeitig profiliert wird, was durch die geeignete Ausbildung der Sägeschneide gewährleistet wird.

Um beim Sägen keine Gratbildung zu bekommen, taucht jedes Sägeblatt nur in die Leiterplatte ein ohne, daß eines der Kreissägeblätter allein die Leiterplatte durchtrennt. Es erfolgt mit einem Sägeblatt also keine vollständige Abtrennung des Randes, was auf der Unterseite der Leiterplatte zu starker Gratbildung führen würde, insbesondere bei Kupferfolien kaschierten Leiterplatten. Die vollständige Durchtrennung der Leiterplatte wird dadurch erzielt, daß das zweite Sägeblatt von der gegenüberliegenden Leiterplattenseite aus in diese eintaucht. Es ist gegenüber dem ersten Sägeblatt so in Umfangsrichtung verdreht eingebaut, daß jeder Zahn des zweiten Sägeblattes in der Zahnlücke des ersten Sägeblattes eingreift, d.h. die Sägeblätter ineinander kämmen ohne sich zu berühren. Voraussetzung, daß die Zähne der beiden Sägeblätter sich auf Dauer nicht berühren, ist, daß der Antrieb beider Sägeblätter synchron erfolgt, was z.B. durch eine starre Verbindung zwischen beiden Sägeblättern mittels Zahnriemen oder Zahnrädern gewährleistet werden kann. Die Eintauchtiefe der Sägeblätter ist variabel.

Der abgeschnittene Rand wird zwischen zwei synchron zur Kreuztischgeschwindigkeit laufenden Andruckrollen geführt und aus dem Arbeitsraum der Maschine heraustransportiert. Nach dem Besäumen der ersten Kante wird die Leiterplatte mittels des Rundschalttisches um 90° gedreht und ein zweites Mal an dem Sägen-Paar vorbeigeführt. Dieser Vorgang wiederholt sich noch zwei Mal, so daß die Leiterplatte am Ende der Bearbeitung an allen vier Kanten besäumt, entgratet und profiliert ist. Hierbei kann die Steuerung des Ablaufs bzw. der Positionierung der Leiterplatte mittels einer CNC-Steuerung erfolgen, die eine einfache Anpassung des Maschinenablaufs an das Leiterplattenformat zuläßt.

Eine bevorzugte Ausführungsform einer Vorrichtung gemäß der Erfindung ist beispielsweise in der Zeichnung dargestellt und zwar zeigen:

Fig. 1     eine schematische Seitenansicht der gesamten Vorrichtung,

Fig. 2     einen Ausschnitt in der Draufsicht A bei Eingriff der Sägeblätter,

Fig. 3     einen Querschnitt beim Eingriff eines der beiden Sägeblätter und

Fig. 4     eine Draufsicht und Querschnitt der beiden kämmenden Sägeblätter beim Eingriff.

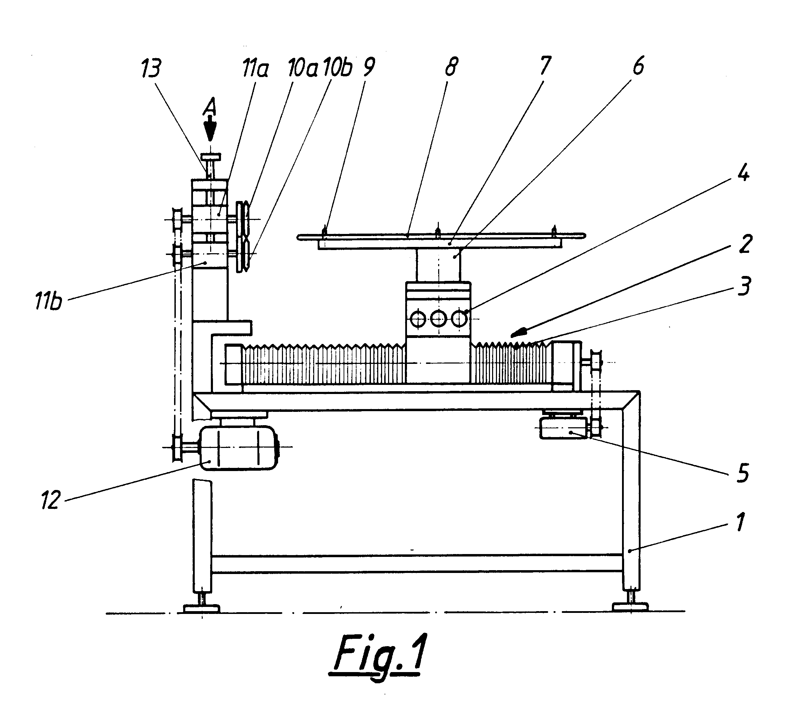

Wie aus der Zeichnung ersichtlich wird, ist nach Fig. 1 auf dem Grundgestell 1 der Kreuztisch 2 aufgebaut mit den Achsen X-3 und Y-4. Der Antrieb 5 der X-Achse ist ebenfalls ersichtlich. Auf der Anschlußfläche der Y-Achse 4 ist der Rundschalttisch 6 angeordnet, auf welchem die Aufspannplatte 7 angeschraubt ist. Die Leiterplatte 8 liegt hierauf (7) und damit auf dem Rundschalttisch 6 und wird mittels der Positionierhilfen 9 in ihrer Lage fixiert. Die beiden Sägeblätter 10a und 10b sind in den Lagerböcken 11a und 11b gelagert und werden über einen gemeinsamen Zahnriemen, der beide Sägeblätterantriebe formschlüssig verbindet, vom Motor 12 angetrieben. Die Lagerböcke 11a und 11b können über die Verstellspindel 13 verstellt werden, um an unterschiedliche Sägeblätter und Leiterplattendicken angepaßt zu werden.

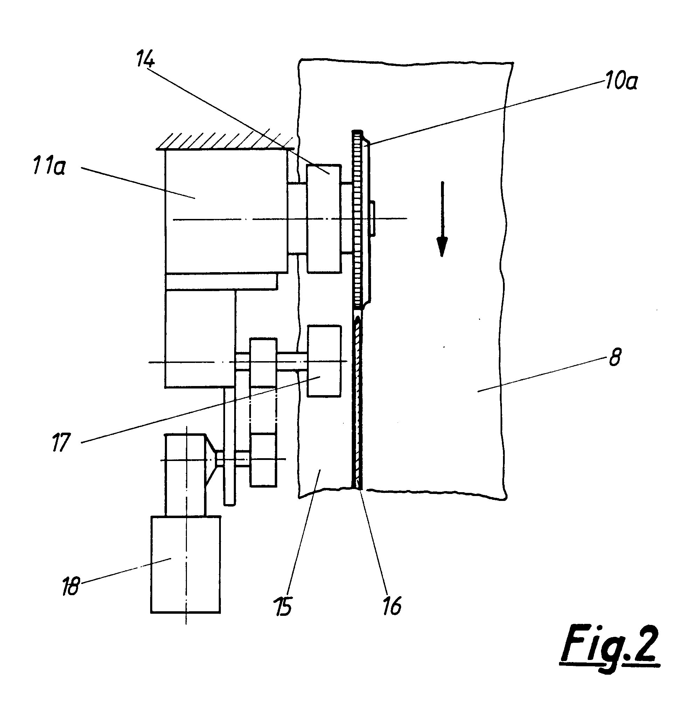

Nach Fig. 2 mit Ansicht A als Ausschnitt auf die Vorrichtung, befindet sich die Leiterplatte 8 in der Arbeitsstation, d.h. beim Besäumen mit den Sägeblättern 10a und 10b. Die Leiterplatte 8 wird während des Sägens von zwei übereinanderliegenden Andruckrollen 14 zentriert. Der abgeschnittene Rand 15 der Leiterplatte 8 wird zwangsweise durch ein Schwert 16 von der restlichen Leiterplatte getrennt und von zwei übereinanderstehenden Rollen 17 aus dem Arbeitsraum transportiert. Der Antrieb der Rollen 17 erfolgt mittels eines angeflanschten Motors 18. Nachdem der Rand vollständig abgetrennt ist, fällt er seitlich aus der Vorrichtung heraus.

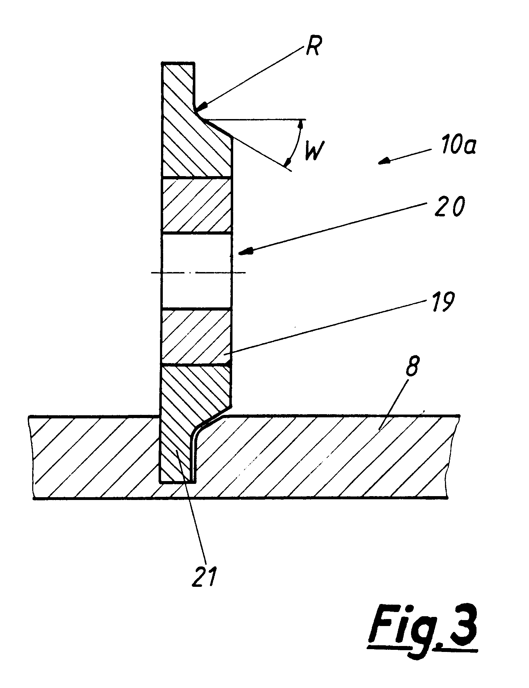

In Fig. 3 ist verdeutlicht, bei nur einem der beiden Sägeblätter 10a im Eingriff mit der Leiterplatte 8, wie der über die Achsbohrung 20 aufgenommene Grundkörper 19 am Umfang mit mehreren Diamant-Schneidzähnen besetzt ist. Diese Schneidzähne 21 sind so ausgebildet, daß sie die Leiterplatte 8 gleichzeitig einschneiden und profilieren. Dazu besitzen diese (21) einen seitlichen Radius R und verbreitern sich, wie ersichtlich, unter einem wählbaren Winkel W zur Sägeblatt-Mitte hin.

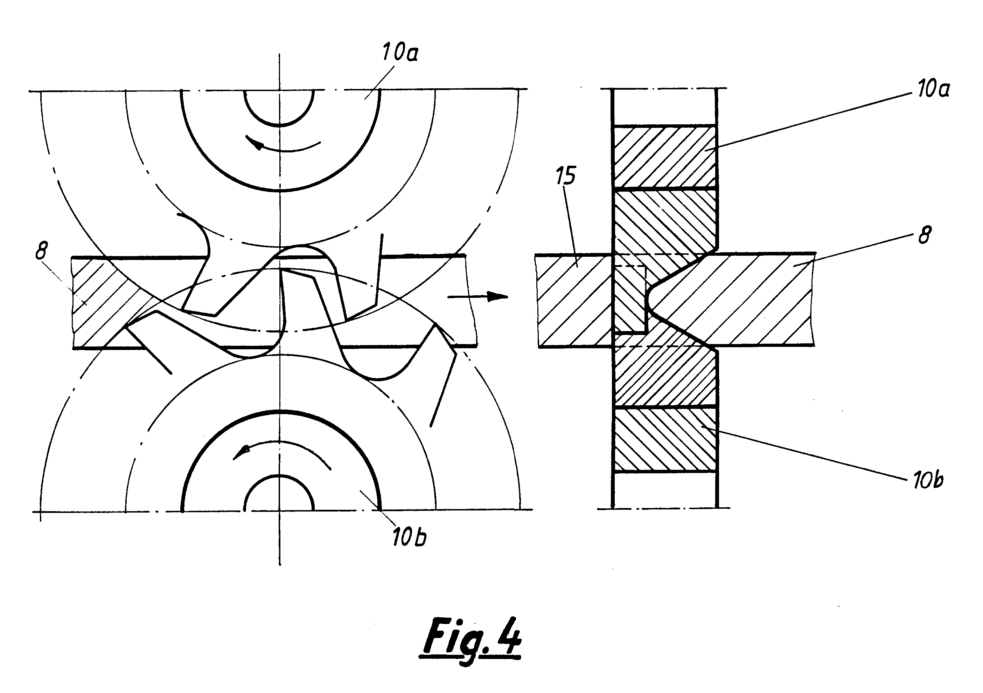

Schließlich zeigt Fig. 4 im Querschnitt einen Ausschnitt zur Seitenansicht der ineinander kämmenden Sägeblätter 10a und 10b mit der Leiterplatte 8. Daraus wird ersichtlich, daß jedes Sägeblatt 10a bzw. 10b in die Leiterplatte nur eintaucht und wie das Profilieren der Leiterplatten-Kante bewerkstelligt wird.

## Patentansprüche

1. Vorrichtung zum Trennen und Besäumen von Leiterplatten (8), insbesondere mehrlagigen Leiterplatten (Multilayers), welche zwei in einer Ebene gegenüberliegend angeordnete Kreissägeblätter (10a, 10b) aufweist, deren Sägezähne beidseitig in die Leiterplatte eintauchen, dadurch gekennzeichnet, daß die Sägezähne der zwei in einer Ebene ineinander gegenüberliegend angeordnete Kreissägeblätter (10a, 10b), die vorzugsweise Diamantschneiden aufweisen, und ineinander kämmend beidseits in die Leiterplatte eintauchen, ohne daß eines der Kreissägeblätter allein die Leiterplatten durchtrennt, zum gratfreien Trennen bzw. Besäumen der Leiterplatten und gleichzeitiger Profilierung entsprechend den Sägezahn-Randprofilen.

2. Vorrichtung nach Anspruch 1, dadurch gekennzeichnet, daß bei festehend angeordneten, synchron laufenden Antrieben für die Sägeblätter (10a, 10b) die Sägezähne (21) - sich nicht berührend - bei variabler Eintauchtiefe ineinander kämmen und die Leiterplatten zum Schnitt zuführbar sind.

3. Vorrichtung nach Anspruch 1 oder 2, dadurch gekennzeichnet, daß die Leiterplatten zur Zufuhr und Schnitt auf auswechselbaren Aufspannplatten (7) aufgelegt sind, welche wenig kleiner als der Randschnitt der Leiterplatten (8) zu wählen sind.

4. Vorrichtung nach einem der Ansprüche 1 bis 3, dadurch gekennzeichnet, daß der jeweils abgeschnittene Rand der Leiterplatten (8) von synchron mit dem Leiterplatten-Vorschub laufenden Rollen (17) aus dem Arbeitsbereich transportierbar ist.

5. Vorrichtung nach einem der Ansprüche 1 bis 4, dadurch gekennzeichnet, daß die auf der auswechselbaren Aufspannplatte aufliegende Leiterplatte während des Schnittes (Sägens) durch zwei übereinanderliegende Andruckrollen (14) zentriert ist.

6. Vorrichtung nach einem der Ansprüche 1 bis 5, dadurch gekennzeichnet, daß die auswechselbaren Aufspannplatten (7) (Wechselplatten) mit einem Positionierungssystem (2) für die aufsetzbaren Leiterplatten ausgerüstet sind.

7.  Vorrichtung nach einem der vorhergehenden Ansprüche,

    dadurch gekennzeichnet, daß der Arbeitsablauf derselben durch eine CNC-Steuerung auf beliebige Formate der Leiterplatten (8) programmierbar ist.

8.  Vorrichtung nach einem der vorhergehenden Ansprüche,

    dadurch gekennzeichnet, daß ein Rundschalttisch (6) mit auswechselbarer Aufspannplatte (7) mit Positionierungssystem für die Leiterplatten zum Auflegen und Randbesäumen derselben vorgesehen ist.

9.  Vorrichtung nach Anspruch 8,

    dadurch gekennzeichnet, daß der Rundschalttisch (6) seinerseits auf einem Kreuztisch (2) montiert ist, dessen beide Achsen (X, Y) mittels Position und Geschwindigkeit regelbaren Motoren (5) zur Erreichung hoher Verkehrsgeschwindigkeiten angetrieben werden.

## Claims

1.  An apparatus for severing and trimming printed circuit boards (8), particularly of multilayer printed circuit boards (multilayers), comprising two circular sawblades (10a, 10b), which are disposed opposite to each other in a plane and have sawteeth, which enter the printed circuit board on opposite sides,

    characterized in that the sawteeth of the two circular sawblades (10a, 10b), which are disposed opposite to each other in a plane, preferably comprise diamond tips and enter the printed circuit board on opposite sides to mesh with each other whereas neither of the circular sawblades alone entirely severs the printed circuit boards, which apparatus serves to sever and/or trim the printed circuit boards and to profile them at the same time in accordance with the edge profiles of the sawteeth.

2.  An apparatus according to claim 1,

    characterized in that fixedly mounted synchronized drives for the sawblades (10a, 10b) are provided and the sawteeth (21) mesh with each other and enter to a variable depth and the printed circuit boards are adapted to be fed for the cut.

3.  An apparatus according to claim 1 or 2, characterized in that the printed circuit boards are deposited for being fed and cut on replaceable fixing plates (7), which are selected to be slightly smaller than the cut edges of the printed circuit boards (8).

4.  An apparatus according to any of claims 1 to 3,

    characterized in that the cut-off edge portion of the printed circuit boards (8) is adapted to be transported out of the working region by rollers (17), which are synchronized with the feeding of the printed circuit boards.

5.  An apparatus according to any of claims 1 to 4,

    characterized in that the printed circuit board which lies on the replaceable fixing plate is centered during the cutting (sawing) operation by two superposed pressure-applying rollers (14).

6.  An apparatus according to any of claims 1 to 5, characterized in that the replaceable fixing plates (7) (change plates) are provided with a system (2) for positioning the depositable printed circuit boards.

7.  An apparatus according to any of the preceding claims,

    characterized in that the sequence of operations of the apparatus is adapted to be programmed by a CNC control for printed circuit boards (8) of any format.

8.  An apparatus according to any of the preceding claims,

    characterized in that a rotary indexing table (6) comprising a replaceable fixing plate (7) provided with a system for positioning the printed circuit boards is provided for the depositing and edge-trimming of the printed circuit boards.

9.  An apparatus according to claim 8,

    characterized in that the rotary indexing table (6) is mounted on a compound table (2), the two axis members (X, Y) of which are driven by motors (5), which are arranged for automatic position and velocity control in order to achieve high speeds of traffic.

## Revendications

1.  Dispositif pour sectionner et rogner des plaquettes à circuits imprimés (8), en particulier des circuits imprimés multicouches (multilayers), comprenant deux lames de scie circulaire (10a, 10b) disposées en face l'une de l'autre dans un même plan et dont les dents plongent des deux côtés dans la plaquette à circuits imprimés, **caractérisé en ce** que les dents de scie des deux lames de scie circulaire (10a, 10b) emboîtées les unes dans les autres dans le même plan présentent de préférence des tranchants diamantés et plongent des deux côtés dans la plaquette à circuits imprimés en s'engrenant les unes dans les autres, sans que l'une des lames de scie circulaire sectionne à elle seule les plaquettes à circuits imprimés, pour obtenir un sectionnement ou rognage sans bavure des plaquettes à circuits imprimés avec profilage simultané suivant les profils latéraux des dents de scie.

2. Dispositif selon la revendication 1, caractérisé en ce que, avec des entraînements synchrones et stationnaires pour les lames de scie (10a, 10b), les dents de scie (21) s'engrènent - sans se toucher - à des profondeurs de plongée variables et que les plaquettes à circuits imprimés peuvent être amenées pour la coupe.

3. Dispositif selon l'une des revendications 1 ou 2, caractérisé en ce que, pour l'amenée et la coupe, les plaquettes à circuits imprimés sont déposées sur des plateaux de fixation (7) interchangeables dont les dimensions doivent être choisies légèrement plus petites que la coupe latérale des plaquettes à circuits imprimés (8).

4. Dispositif selon l'une des revendications 1 à 3, caractérisé en ce que le bord des plaquettes à circuits imprimés (8) respectivement coupé peut être évacué de la zone de travail par des rouleaux (17) qui tournent en synchronisme avec l'avancement des plaquettes à circuits imprimés.

5. Dispositif selon l'une des revendications 1 à 4, caractérisé en ce que la plaquette à circuits imprimés qui repose sur le plateau de fixation interchangeable est centrée pendant la coupe (sciage) par deux rouleaux presseurs (14) superposés.

6. Dispositif selon l'une des revendications 1 à 5, caractérisé en ce que les plateaux de fixation interchangeables (7) (plateaux de rechange) sont équipés d'un système de positionnement (2) pour les plaquettes à circuits imprimés pouvant être mises en place.

7. Dispositif selon l'une des revendications précédentes, caractérisé en ce que les phases de travail de celui-ci peuvent être programmées par une commande CNC pour des formats quelconques des plaquettes à circuits imprimés (8).

8. Dispositif selon l'une des revendications précédentes, caractérisé en ce qu'une table à transfert circulaire (6) avec plateau de fixation interchangeable (7) et système de positionnement pour les plaquettes à circuits imprimés est prévue pour la mise en place et le rognage desdites plaquettes.

9. Dispositif selon la revendication 8, caractérisé en ce que la table à transfert circulaire (6) est montée à son tour sur une table à mouvements croisés (2) dont les deux axes (X, Y) sont entraînés au moyen de moteurs (5) permettant de régler la position et la vitesse pour obtenir des vitesses de circulation élevées.

*Fig.1*

Fig.2

EP 0 315 739 B1

_Fig.3_

**_Fig.4_**

EP 0 315 739 B1